# EUROPEAN PATENT APPLICATION

(11) **EP 4 579 720 A2**
(43) Date of publication of application: **02.07.2025**
(21) Application number: 24222401.2
(22) Date of filing: 20.12.2024
(51) Int. Cl.: H01L 21/66, H01L 23/58

(54) **SEMICONDUCTOR DEVICE**

(30) Priority: 29.12.2023 US 202363615819 P; 27.11.2024 US 202418961983
(71) Applicant: MediaTek Inc., Hsinchu City, 30078 (TW)
(72) Inventor: JHAN, Cing-Yao, 30078 Hsinchu City (TW); HUANG, Chien-Kai, 30078 Hsinchu City (TW); SHIH, Ting-Chen, 30078 Hsinchu City (TW); FAN, Sheng-Hung, 30078 Hsinchu City (TW); LU, Tien-Yu, 30078 Hsinchu City (TW); TSAI, Shang-Yu, 30078 Hsinchu City (TW); LU, Man-Ling, 30078 Hsinchu City (TW); HU, Chu-Wei, 30078 Hsinchu City (TW)
(74) Representative: Haseltine Lake Kempner LLP

(57) **Abstract**

A semiconductor device includes a first semiconductor component, a second semiconductor component, and a damage detection structure. The first semiconductor component includes a first edge region. The second semiconductor component is stacked below the first semiconductor component and includes a second edge region. The damage detection structure includes a plurality of first conductive paths and a plurality of second conductive paths. The first conductive paths are disposed in the first edge region. The second conductive paths are disposed in the second edge region and are electrically coupled to the first conductive paths.

## Description

This application claims the benefit of U.S. Provisional Application No. 63/615,819 filed on December 29, 2023, the entirety of which is incorporated by reference herein.

### BACKGROUND OF THE INVENTION

### Field of the Invention

The present invention relates to semiconductor technology, and, in particular, to a semiconductor device that includes a damage detection structure.

### Description of the Related Art

Semiconductor devices are widely used in various electronic applications, such as personal computers, mobile phones, digital cameras, and other electronic equipment. As the size of semiconductor devices shrinks, the difficulty of manufacturing semiconductor devices has also increased significantly. Defects may occur during the process of manufacturing semiconductor devices, and these defects may cause failure, or they may cause the performance of the semiconductor device to suffer.

For example, semiconductor dies are generally singulated from a wafer in a dicing process, and the edges of these semiconductor dies may crack or become damaged during the dicing process. The cracks and damage may propagate and become significant during subsequent stages of the manufacturing process, or during the lifetime of the semiconductor dies. Therefore, there is a need to detect such cracks and other damage in an early stage. Further improvements in semiconductor devices are required.

### BRIEF SUMMARY OF THE INVENTION

Semiconductor devices are provided. An exemplary embodiment of a semiconductor device includes a first semiconductor component, a second semiconductor component, and a damage detection structure. The first semiconductor component includes a first edge region. The second semiconductor component is stacked below the first semiconductor component and includes a second edge region. The damage detection structure includes a plurality of first conductive paths and a plurality of second conductive paths. The first conductive paths are disposed in the first edge region. The second conductive paths are disposed in the second edge region and are electrically coupled to the first conductive paths.

Another embodiment of a semiconductor device includes a first semiconductor component, a second semiconductor component, and a damage detection structure. The first semiconductor component vertically overlaps the second semiconductor component. The damage detection structure includes a plurality of first conductive paths and a plurality of second conductive paths. The first conductive paths extend along a first edge of the first semiconductor component. The second conductive paths extend along a second edge of the second semiconductor component and are electrically coupled to the first conductive paths. The first conductive paths and the second conductive paths are in a first staggered arrangement.

Yet another embodiment of a semiconductor package structure includes first stacked structure and a damage detection structure. The first stacked structure includes a first semiconductor component and a second semiconductor component. The damage detection structure is disposed in an edge region of the first stacked structure and includes a first conductive path. The first conductive path continuously surrounds a first active region of the first semiconductor component and a second active region of the second semiconductor component in a zigzag shape.

### BRIEF DESCRIPTION OF THE DRAWINGS

The present invention can be more fully understood by reading the subsequent detailed description and examples with references made to the accompanying drawings, wherein:
FIG. 1A is a top view of an exemplary semiconductor device in accordance with some embodiments of the present disclosure;
FIG. 1B is a perspective view of an exemplary semiconductor device in accordance with some embodiments of the present disclosure;
FIG. 2A is a top view of an exemplary semiconductor device in accordance with some embodiments of the present disclosure;
FIG. 2B is a perspective view of an exemplary semiconductor device in accordance with some embodiments of the present disclosure;
FIG. 3A is a top view of an exemplary semiconductor device in accordance with some embodiments of the present disclosure;
FIG. 3B is a perspective view of an exemplary semiconductor device in accordance with some embodiments of the present disclosure;
FIG. 4 is a cross-sectional view of an exemplary semiconductor device in accordance with some embodiments of the present disclosure; and
FIGs. 5 to 9 are perspective views of exemplary semiconductor devices in accordance with some embodiments of the present disclosure.

### DETAILED DESCRIPTION OF THE INVENTION

The following description is made for the purpose of illustrating the general principles of the invention and should not be taken in a limiting sense. The scope of the invention is best determined by reference to the appended claims.

The present disclosure will be described with respect to particular embodiments and with reference to certain drawings, but the disclosure is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the disclosure.

Additional elements may be added on the basis of the embodiments described below. For example, the description of "a first element on/over a second element" may include embodiments in which the first element is in direct contact with the second element, and may also include embodiments in which additional elements are disposed between the first element and the second element such that the first element and the second element are not in direct contact.

The spatially relative descriptors of the first element and the second element may change as the structure is operated or used in different orientations. In addition, the present disclosure may repeat reference numerals and/or letters in the various embodiments. This repetition is for simplicity and clarity and does not in itself dictate a relationship between the various embodiments discussed.

A semiconductor device including a damage detection structure is described in accordance with some embodiments of the present disclosure. The damage detection structure may be disposed in edge regions and may surround active regions of stacked semiconductor components, which may include a semiconductor die, an interposer, the like, or a combination thereof. As a result, damages in the edge regions of the stacked semiconductor components can be detected before reaching the active areas.

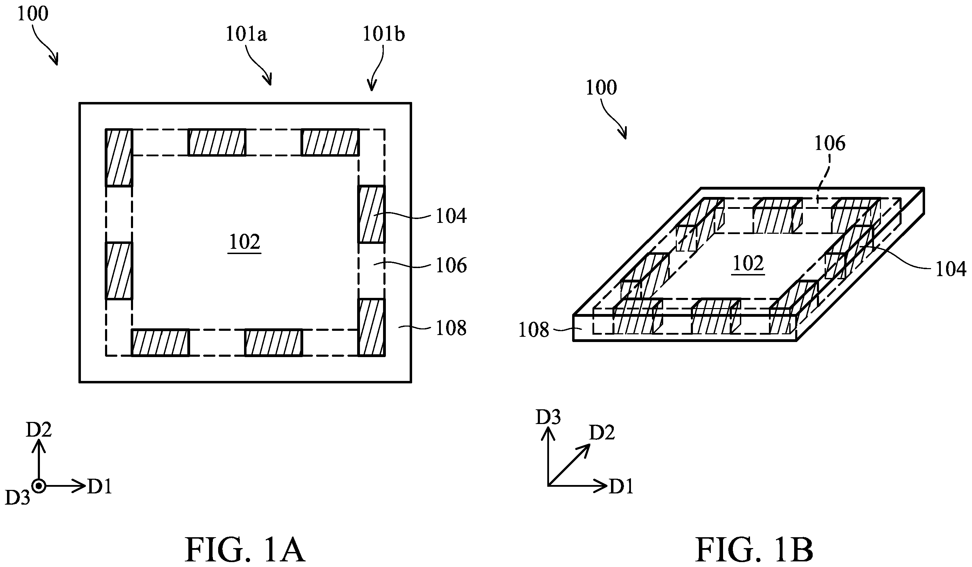

FIG. 1A is a top view of a first semiconductor device 100 in accordance with some embodiments of the present disclosure. FIG. 1B is a perspective view of the first semiconductor device 100 in accordance with some embodiments of the present disclosure. Additional features can be added to the first semiconductor device 100. Some of the features described below can be replaced or eliminated for different embodiments. To simplify the diagram, only a portion of the first semiconductor device 100 is illustrated.

As illustrated in FIG. 1A, a first semiconductor device 100 is provided, in accordance with some embodiments. The first semiconductor device 100 may include a first semiconductor component 102. The first semiconductor component 102 may include an active region 101a and an edge region 101b surrounding the active region 101a.

In some embodiments, the first semiconductor component 102 is a semiconductor die, and includes a system-on-chip (SoC) die, a logic device, a memory device, a radio frequency (RF) device, the like, or any combination thereof. For example, the first semiconductor component 102 may include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or a combination thereof.

The first semiconductor device 100 includes a plurality of first conductive paths 104 disposed in the edge region 101b of the first semiconductor component 102, in accordance with some embodiments. The first conductive paths 104 may include multiple separate segments disposed along the edges of the first semiconductor component 102. A plurality of first dielectric layers 106 may be disposed between two of the first conductive paths 104 and may separate them apart from each other.

As shown in FIG. 1B, the first conductive paths 104 may be spaced apart from each other in the direction D1 and the direction D2 and may be continuous in the direction D3. The directions D1, D2, and D3 may be different from each other. The directions D1, D2, and D3 may be substantially perpendicular to each other. In some embodiments, the angle between any two of the directions D1, D2, and D3 is about 85° to 90°.

The first semiconductor device 100 includes a seal ring 108 surrounding the first semiconductor component 102. The seal ring 108 may laterally enclose the first semiconductor component 102 to provide protection from water, chemicals, residue, contaminants, or the like that may be present during processing the first semiconductor component 102. The seal ring 108 may be formed of a conductive material, such as metal, including copper, copper alloy, or any suitable material.

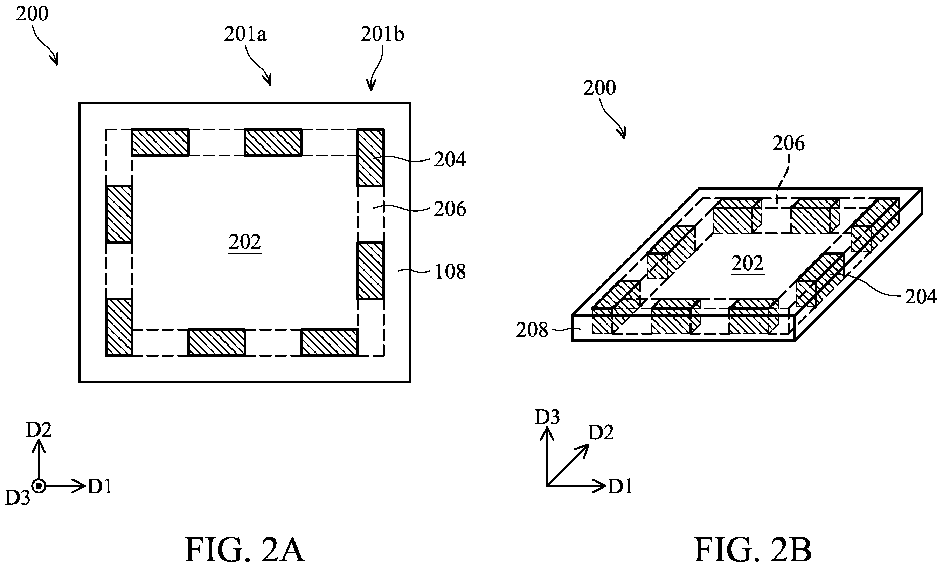

FIG. 2A is a top view of a second semiconductor device 200 in accordance with some embodiments of the present disclosure. FIG. 2B is a perspective view of the second semiconductor device 200 in accordance with some embodiments of the present disclosure. Additional features can be added to the second semiconductor device 200. Some of the features described below can be replaced or eliminated for different embodiments. To simplify the diagram, only a portion of the second semiconductor device 200 is illustrated.

As illustrated in FIG. 2A, a second semiconductor device 200 is provided, in accordance with some embodiments. The second semiconductor device 200 may include a second semiconductor component 202. The second semiconductor component 202 may include an active region 201a and an edge region 201b surrounding the active region 201a.

In some embodiments, the second semiconductor component 202 is a semiconductor die, and includes a system-on-chip (SoC) die, a logic device, a memory device, a radio frequency (RF) device, the like, or any combination thereof. For example, the second semiconductor component 202 may include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or a combination thereof.

In some other embodiments, the second semiconductor component 202 is an interposer. The interposer may include a bulk semiconductor, a compound semiconductor, an alloy semiconductor, the like, or a combination thereof, and may be formed of silicon, germanium, or any suitable semiconductor material. The interposer may include a wiring structure therein.

The first semiconductor component 102 and the second semiconductor component 202 may include the same or different components.

The second semiconductor device 200 includes a plurality of second conductive paths 204 disposed in the edge region 201b of the second semiconductor component 202, in accordance with some embodiments. The second conductive paths 204 may include multiple separate segments along the edges of the second semiconductor component 202. A plurality of second dielectric layers 206 may be disposed between two of the second conductive paths 204 and may space them apart from each other.

As shown in FIG. 2B, the second conductive paths 204 may be spaced apart from each other in the direction D1 and the direction D2 and may be continuous in the direction D3. The directions D1, D2, and D3 may be different from each other. The directions D1, D2, and D3 may be substantially perpendicular to each other. In some embodiments, the angle between any two of the directions D1, D2, and D3 is about 85° to 90°.

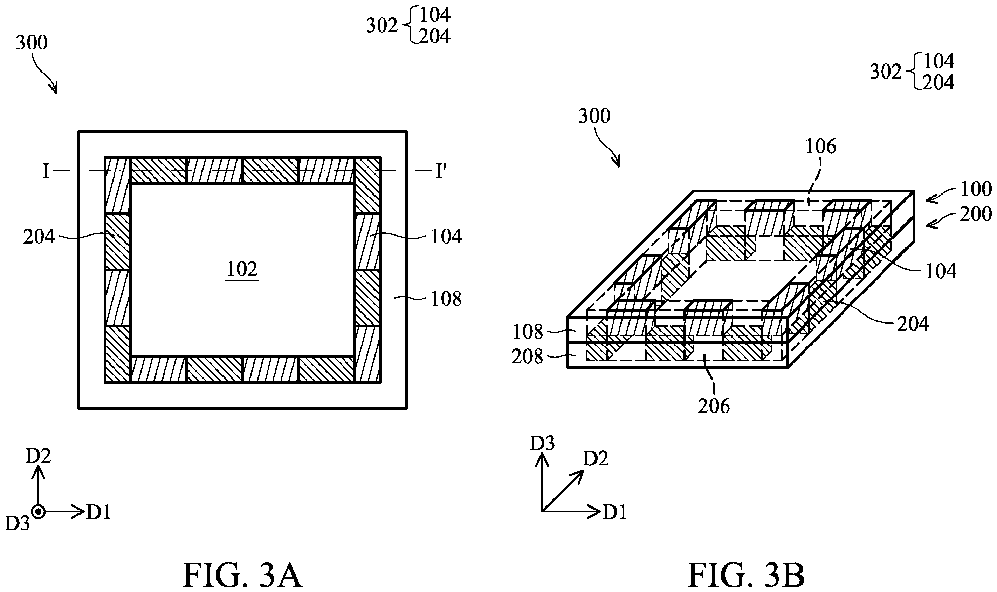

FIG. 3A is a top view of a semiconductor device 300 in accordance with some embodiments of the present disclosure. FIG. 3B is a perspective view of the semiconductor device 300 in accordance with some embodiments of the present disclosure. It should be noted that the semiconductor device 300 may include the same or similar components as those of the first semiconductor device 100 and the second semiconductor device 200, and for the sake of simplicity, those components will not be discussed in detail again.

As illustrated in FIG. 3B, a semiconductor device 300 includes the first semiconductor device 100 and the second semiconductor device 200, in accordance with some embodiments. The first semiconductor device 100 and the second semiconductor device 200 may be stacked in the direction D3. The first semiconductor component 102 may be flipped upside down and disposed over the second semiconductor component 202, so that the first semiconductor component 102 and the second semiconductor component 202 may be assembled face-to-face.

The first semiconductor device 100 may vertically overlap the second semiconductor device 200. The first semiconductor device 100 and the second semiconductor device 200 may include similar areas. In particular, the active region 101a of the first semiconductor component 102 may vertically overlap the active region 201a of the second semiconductor component 202, and the edge region 101b of the first semiconductor component 102 may vertically overlap the edge region 201b of the second semiconductor component 202.

The first conductive paths 104 may be spaced apart from each other, and the second conductive paths 204 may be spaced apart from each other. In some embodiments, the first conductive paths 104 and the second conductive paths 204 are in a staggered arrangement. Thus, each of the first conductive paths 104 may be disposed between two of the second conductive paths 204, and each of the second conductive paths 204 may be disposed between two of the first conductive paths 104 in the top view, as shown in FIG. 3A.

The staggered first conductive paths 104 and second conductive paths 204 may form a damage detection structure 302. As shown in FIG. 3B, the damage detection structure 302 may continuously surround the active areas of the stacked first semiconductor component 102 and second semiconductor component 202.

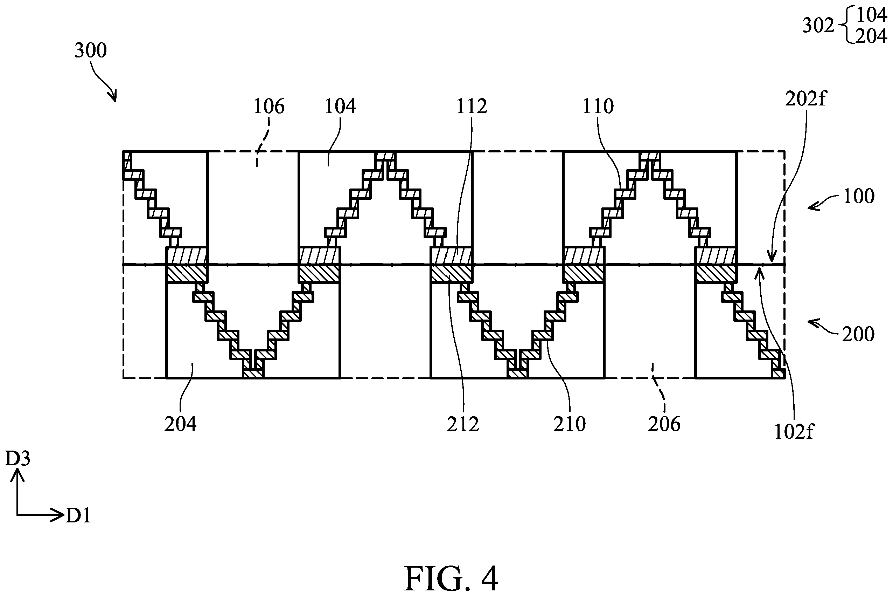

FIG. 4 is a cross-sectional view of the semiconductor device 300 taken along line I-I' shown in FIG. 3A. As shown in FIG. 4, two of the first conductive paths 104 may be spaced apart by one of the first dielectric layers 106, and two of the second conductive paths 204 may be spaced apart by one of the second dielectric layers 206. In some embodiments, the first dielectric layers 106 and the second dielectric layers 206 are in a staggered arrangement.

Each of the first conductive paths 104 may include a plurality of conductive vias 110 and a plurality of conductive pads 112, in accordance with some embodiments. The conductive vias 110 and the conductive pads 112 may be formed of metal, including copper, silver, gold, the like, an alloy thereof, or a combination thereof. The conductive pads 112 may be disposed on the frontside surface 102f of the first semiconductor component 102. The conductive vias 110 may be stacked over the conductive pads 112 in the direction D3. The conductive vias 110 may be electrically coupled to the conductive pads 112.

The first conductive paths 104 may include a plurality of inverted V shapes as illustrated in FIG. 4. However, the present disclosure is not limited thereto, and the first conductive paths 104 may include any suitable shapes, such as inverted U shapes, inverted M shapes, inverted W shapes, inverted ladder shapes, or the like.

Similarly, each of the second conductive paths 204 may include a plurality of conductive vias 210 and a plurality of conductive pads 212, in accordance with some embodiments. The conductive vias 210 and the conductive pads 212 may be formed of metal, including copper, silver, gold, the like, an alloy thereof, or a combination thereof. The conductive pads 212 may be disposed on the frontside surface 202f of the second semiconductor component 202. The conductive vias 210 may be stacked below the conductive pads 212 in the direction D3. The conductive vias 210 may be electrically coupled to the conductive pads 212.

The second conductive paths 204 may include a plurality of V shapes as illustrated in FIG. 4. Similar to the discussion of the first conductive paths 104, the second conductive paths 204 may include any suitable shapes, such as U shapes, M shapes, W shapes, ladder shapes, or the like. Therefore, the damage detection structure 302 may be in a zigzag shape across the edge regions of the stacked first semiconductor component 102 and the second semiconductor component 202, as shown in FIG. 4.

The conductive pads 212 of the second conductive paths 204 may be electrically coupled to the conductive pads 112 of the first conductive paths 104. According to some embodiments, the conductive pads 212 of the second conductive paths 204 may be in contact with the conductive pads 112 of the first conductive paths 104.

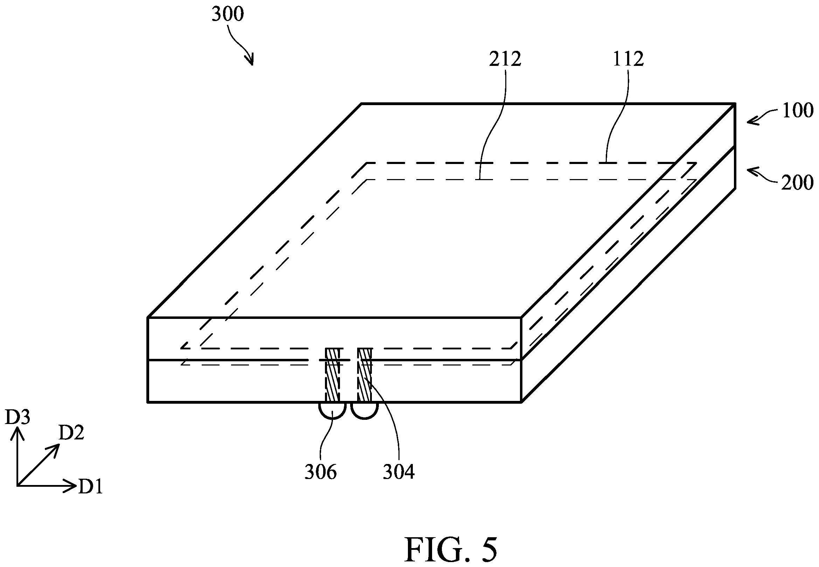

The positions of the conductive pads 112 and 212 are described with reference to FIG. 5. FIG. 5 is a perspective view of the semiconductor device 300 in accordance with some embodiments of the present disclosure. As shown in FIG. 5, the position of each of the conductive pads 112 may corresponds to the position of each of the conductive pads 212.

The semiconductor device 300 includes conductive paths 304 in the second semiconductor device 200 and conductive terminals 306 below the bottom surface of the second semiconductor device 200, in accordance with some embodiments. The conductive terminals 306 may be electrically coupled to the first conductive paths 104 and the second conductive paths 204 through the conductive paths 304. The conductive paths 304 may be connected to the conductive pads 112 and 212 or any suitable portion of the damage detection structure 302.

The conductive paths 304 may include conductive lines, conductive pads, conductive vias, or the like. The conductive paths 304 may be formed of metal, including copper, silver, gold, the like, an alloy thereof, or a combination thereof. The conductive terminals 306 may include microbumps, controlled collapse chip connection (C4) bumps, solder balls, ball grid array (BGA) balls, the like, or a combination thereof. The conductive terminals 306 may be formed of metal, such as tungsten, titanium, tantalum, ruthenium, cobalt, copper, aluminum, platinum, tin, silver, gold, the like, an alloy thereof, or a combination thereof.

Damages in the first semiconductor component 102 and the second semiconductor component 202 may be detected through physical failure analysis (PFA). According to some embodiments, during monitoring damages, a signal is generated and transmitted through the damage detection structure 302, and then a disruption of the signal due to a damage is monitored. Therefore, the damages in the edge regions of the stacked first semiconductor component 102 and second semiconductor component 202 can be detected before reaching the active areas. Consequently, die damage issues and the RMA rate can be reduced.

In addition, since the first conductive paths 104 is electrically coupled to the second conductive paths 204, information related to the damages in the edge region 101b of the first semiconductor component 102 and in the edge region 201b of the second semiconductor component 202 can be obtained at one time without monitoring multiple times.

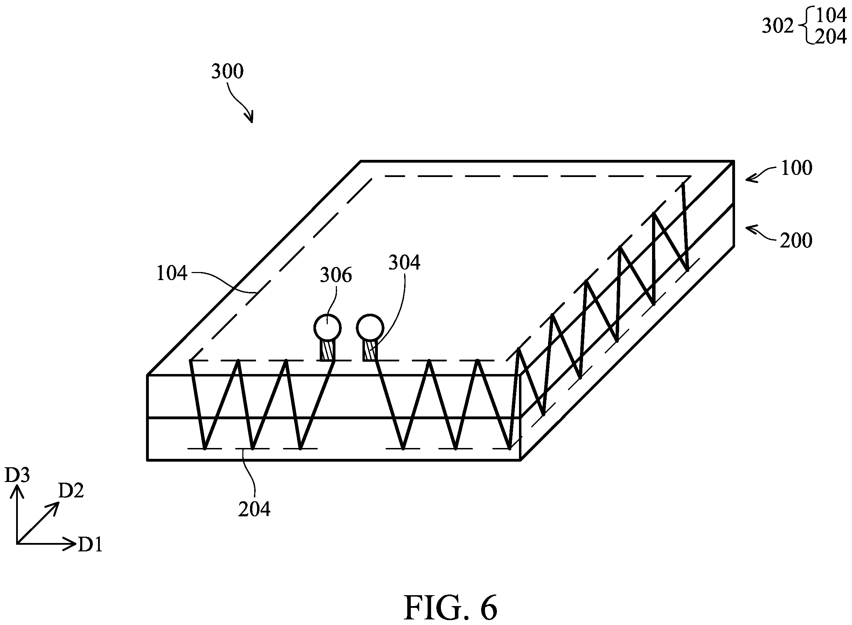

The positions of the first conductive paths 104 and the second conductive paths 204 are described with reference to FIG. 6. FIG. 6 is a perspective view of the semiconductor device 300 in accordance with some embodiments of the present disclosure. Only a portion of the first conductive paths 104 and the second conductive paths 204 are illustrated for simplicity. As shown in FIG. 6, the first conductive paths 104 and the second conductive paths 204 may be in a staggered arrangement. The damage detection structure 302 may be in a zigzag shape, and the turning points of the zigzag shape may be adjacent to the top surface of the first semiconductor device 100 and the bottom surface of the second semiconductor device 200, respectively.

The positions of the conductive paths 304 and the conductive terminals 306 may be adjusted. For example, the conductive terminals 306 may be disposed over the top surface of the first semiconductor device 100 as illustrated in FIG. 6. Alternatively, the conductive paths 304 may be disposed in the second semiconductor device 200, and the conductive terminals 306 may be disposed below the bottom surface of the second semiconductor device 200, as illustrated in FIG. 5. Furthermore, the numbers of the conductive paths 304 and the conductive terminals 306 may be adjusted. For example, the semiconductor device 300 may include more than two conductive paths 304 and/or more than two conductive terminals 306.

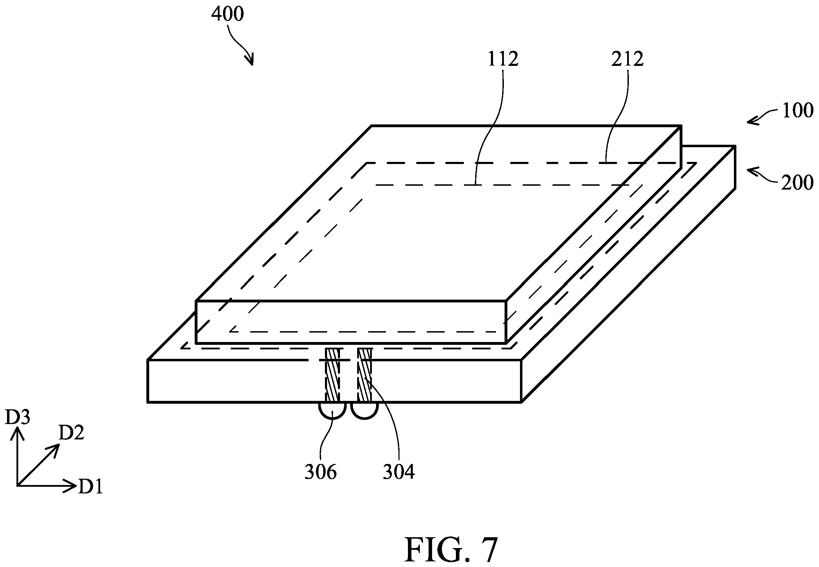

FIG. 7 is a perspective view of the semiconductor device 400 in accordance with some embodiments of the present disclosure. It should be noted that the semiconductor device 400 may include the same or similar components as those of the semiconductor device 300, and for the sake of simplicity, those components will not be discussed in detail again. In the following embodiments, the area of the first semiconductor device 100 is different from the area of the second semiconductor device 200.

As illustrated in FIG. 7, the area of the second semiconductor device 200 may be greater than the area of the first semiconductor device 100. For example, the second semiconductor device 200 may be an interposer and the first semiconductor device 100 may be a semiconductor die. In particular, the edge region of the second semiconductor component 202 may surround the edge region of the first semiconductor component 102 when viewing in the direction vertical to the top surface of the first semiconductor device 100. The conductive pads 212 may be outside of (such as surround) the conductive pads 112.

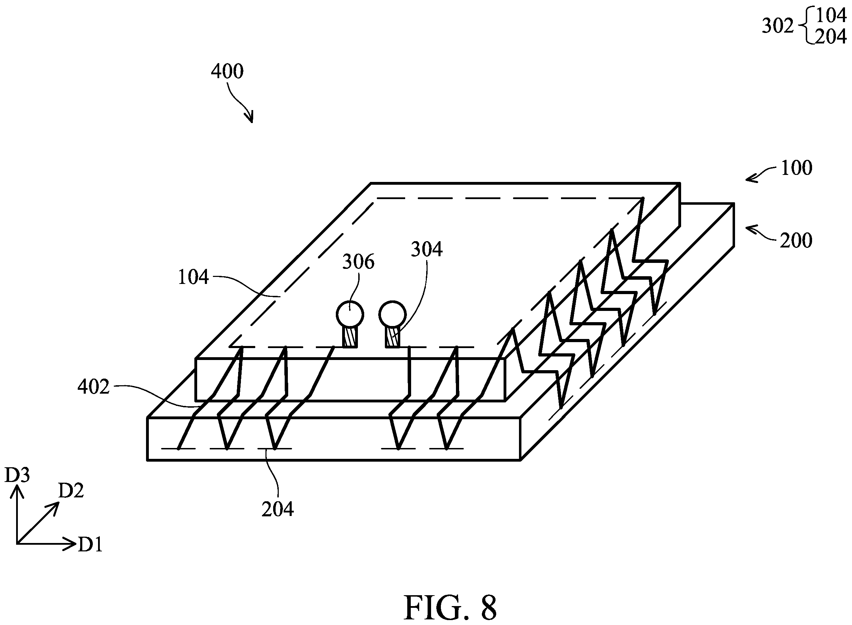

The positions of the first conductive paths 104 and the second conductive paths 204 are described with reference to FIG. 8. FIG. 8 is a perspective view of the semiconductor device 400 in accordance with some embodiments of the present disclosure. Only a portion of the first conductive paths 104 and the second conductive paths 204 are illustrated for simplicity. As shown in FIG. 8, the first conductive paths 104 and the second conductive paths 204 may be in a staggered arrangement. The first conductive paths 104 may be spaced apart from the second conductive paths 204.

The damage detection structure 302 include a plurality of conductive lines 402 extending along the top surface of the second semiconductor device 200, in accordance with some embodiments. The conductive lines 402 may electrically couple the second conductive paths 204 to the first conductive paths 104. The conductive lines 402 may be formed of metal, including copper, silver, gold, the like, an alloy thereof, or a combination thereof. The conductive lines 402 may extend below the bottom surface of the first semiconductor device 100 and may below the seal ring (such as the seal ring 108 in FIG. 3B) of the first semiconductor device 100.

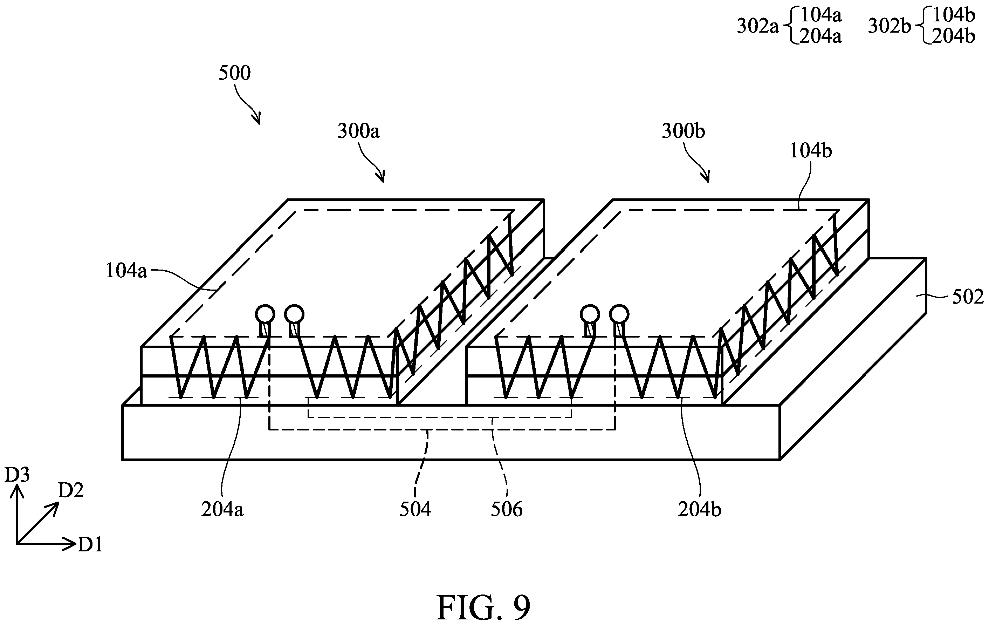

FIG. 9 is a cross-sectional view of a semiconductor device 500 in accordance with some embodiments of the present disclosure. It should be noted that the semiconductor device 500 may include the same or similar components as that of the semiconductor device 300, and for the sake of simplicity, those components will not be discussed in detail again. In the following embodiments, more than two semiconductor components are monitored.

As illustrated in FIG. 9, a substrate 502 is provided, in accordance with some embodiments. The substrate 502 may be a package substrate. The substrate 502 may be a printed circuit board (PCB). The substrate 502 may include a bulk semiconductor, a compound semiconductor, an alloy semiconductor, the like, or a combination thereof, and may be formed of silicon, germanium, or any suitable semiconductor material. The substrate 502 may include a wiring structure therein. The substrate 502 may be a coreless substrate or may include an insulating core, such as a fiberglass reinforced resin core, to prevent the substrate 502 from warpage.

The semiconductor device 500 includes a first stacked structure 300a and a second stacked structure 300b disposed over the substrate 502, in accordance with some embodiments. Each of the first stacked structure 300a and the second stacked structure 300b may include the same or similar components as that of the semiconductor device 300 as illustrated in FIG. 6. In particular, the first stacked structure 300a and the second stacked structure 300b may each include stacked semiconductor components similar to the first semiconductor component 100 and the second semiconductor component 200 as illustrated in FIG. 6.

A damage detection structure may include a first portion 302a disposed in the edge regions of the semiconductor components of the first stacked structure 300a and a second portion 302b disposed in the edge regions of the semiconductor components of the second stacked structure 300b. The first portion 302a and the second portion 302b of the damage detection structure may each include the first conductive paths 104 and the second conductive paths 204 as illustrated in FIG. 6.

The damage detection structure may further include a plurality of third conductive paths 504 and 506 disposed in the substrate 502. The third conductive paths 504 and 506 may electrically couple the first portion 302a to the second portion 302b of the damage detection structure.

The semiconductor device 500 may include additional conductive paths and two or more conductive terminals (not illustrated). For example, the conductive paths may be disposed in the substrate 502 and the conductive terminals may be disposed below the bottom surface of the substrate 502. The conductive terminals may be electrically coupled to the damage detection structure through the conductive paths. Since the damage detection structure surrounds four semiconductor components, information related to the damages in the edge regions of these semiconductor components can be monitored at one time without monitoring multiple times.

It should be noted that the two stacked structures 300a and 300b are for illustrative purposes only, and more stacked structures may be disposed over the substrate 502. In addition, the first stacked structure 300a and/or the second stacked structure 300b may include semiconductor devices which have different areas, such as those described with reference to FIG. 8. Furthermore, additional semiconductor components (such as semiconductor dies, resistors, capacitors, or inductors) may also be disposed over the substrate 502.

The present disclosure can be applied to system on integrated chips (SoIC), integrated fan out (InFO), chip on wafer on substrate (CoWoS), 2.5-dimensional (2.5D)/three-dimensional (3D) integrated circuit (IC), or any suitable semiconductor package structure.

In summary, the semiconductor device according to the present disclosure includes a damage detection structure disposed in edge regions and surround active regions of semiconductor components, so that the damages in the edge regions can be detected before reaching the active areas. As a result, die damage issues and the RMA rate can be reduced. Moreover, by adjusting the arrangement of the damage detection structure, information related to the damages in the edge regions of these semiconductor components can be obtained at one time without monitoring multiple times.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.
1. A semiconductor device, comprising:
   a first semiconductor component comprising a first edge region;
   a second semiconductor component stacked below the first semiconductor component and comprising a second edge region; and
   a damage detection structure comprising:
      a plurality of first conductive paths disposed in the first edge region; and
      a plurality of second conductive paths disposed in the second edge region and electrically coupled to the plurality of first conductive paths.
2. The semiconductor device of clause 1, wherein the plurality of first conductive paths are spaced apart from each other, and the plurality of second conductive paths are spaced apart from each other.
3. The semiconductor device of clause 1, wherein the plurality of first conductive paths comprises a plurality of first conductive pads, the plurality of second conductive paths comprises a plurality of second conductive pads, and each of the first conductive pads is in direct contact with one of the second conductive pads.
4. The semiconductor device of clause 1, wherein the first conductive paths comprise inverted V shapes, inverted U shapes, inverted M shapes, inverted W shapes, inverted ladder shapes, or a combination thereof, and the second conductive paths comprise V shapes, U shapes, M shapes, W shapes, ladder shapes, or a combination thereof.
5. The semiconductor device of clause 1, wherein the first semiconductor component and the second semiconductor component are semiconductor dies.
6. The semiconductor device of clause 1, wherein the first semiconductor component is a semiconductor die, and the second semiconductor component is an interposer.
7. The semiconductor device of clause 6, further comprising:
   conductive lines extending along a top surface of the second semiconductor component and electrically coupling the plurality of second conductive paths to the plurality of first conductive paths.
8. The semiconductor device of clause 1, further comprising:
   a substrate stacked below the second semiconductor component,
   wherein the damage detection structure further comprises a plurality of third conductive paths disposed in the substrate and electrically coupled to the plurality of first conductive paths and/or the plurality of second conductive paths.
9. A semiconductor device, comprising:
   a first semiconductor component vertically overlapping a second semiconductor component; and
   a damage detection structure comprising:
      a plurality of first conductive paths extending along a first edge of the first semiconductor component; and
      a plurality of second conductive paths extending along a second edge of the second semiconductor component and electrically coupled to the plurality of first conductive paths,
      wherein the plurality of first conductive paths and the plurality of second conductive paths are in a first staggered arrangement.
10. The semiconductor device of clause 9, wherein the first semiconductor component and the second semiconductor component are assembled face-to-face.
11. The semiconductor device of clause 9, further comprising:
   conductive terminals disposed over a top surface of the first semiconductor component and/or below a bottom surface of the second semiconductor component,
   wherein the conductive terminals are electrically coupled to the plurality of first conductive paths and the plurality of second conductive paths.
12. The semiconductor device of clause 9, further comprising:
   a plurality of first dielectric layers separating adjacent first conductive paths; and
   a plurality of second dielectric layers separating adjacent second conductive paths,
   wherein the plurality of first dielectric layers and the plurality of second dielectric layers are in a second staggered arrangement.
13. The semiconductor device of clause 9, further comprising:
   a seal ring surrounding the damage detection structure.
14. The semiconductor device of clause 9, wherein the first edge of the first semiconductor component vertically overlaps the second edge of the second semiconductor component.
15. The semiconductor device of clause 9, wherein the second edge of the second semiconductor component surrounds the first edge of the first semiconductor component in a top view.
16. A semiconductor device, comprising:
   a first stacked structure comprising a first semiconductor component and a second semiconductor component; and
   a damage detection structure disposed in an edge region of the first stacked structure and comprising a first conductive path,
      wherein the first conductive path continuously surrounds a first active area of the first semiconductor component and a second active region of the second semiconductor component in a zigzag shape.
17. The semiconductor device of clause 16, wherein the zigzag shape comprises a plurality of inverted V shapes adjacent to the first active region of the first semiconductor component and a plurality of V shapes adjacent to the second active region of the second semiconductor component.
18. The semiconductor device of clause 17, wherein each of the inverted V shapes is disposed between two of the V shapes in a top view.
19. The semiconductor device of clause 16, further comprising:
   a substrate disposed below the first stacked structure; and
   a second stacked structure disposed over the substrate and comprising a third semiconductor component and a fourth semiconductor component,
   wherein the damage detection structure further comprises:
      a second conductive path surrounding a third active region of the third semiconductor component and a fourth active region of the fourth semiconductor component; and
      third conductive paths disposed in the substrate and electrically coupling the second conductive path to the first conductive path.
20. The semiconductor device of clause 16, wherein the first conductive path comprises conductive vias and conductive pads.

## Claims

1. A semiconductor device (100, 200, 300, 400, 500), comprising:
a first semiconductor component (100, 102) comprising a first edge region (101b, 201b);
a second semiconductor component (200, 202) stacked below the first semiconductor component (100, 102) and comprising a second edge region (101b, 201b); and
a damage detection structure (302) comprising:
a plurality of first conductive paths (104) disposed in the first edge region (101b, 201b); and
a plurality of second conductive paths (204) disposed in the second edge region (101b, 201b) and electrically coupled to the plurality of first conductive paths (104).

2. The semiconductor device (100, 200, 300, 400, 500) as claimed in claim 1, wherein the plurality of first conductive paths (104) are spaced apart from each other, and the plurality of second conductive paths (204) are spaced apart from each other.

3. The semiconductor device (100, 200, 300, 400, 500) as claimed in claim 1, wherein the plurality of first conductive paths (104) comprises a plurality of first conductive pads (112, 212), the plurality of second conductive paths (204) comprises a plurality of second conductive pads (112, 212), and each of the first conductive pads (112, 212) is in direct contact with one of the second conductive pads (112, 212).

4. The semiconductor device (100, 200, 300, 400, 500) as claimed in claim 1, wherein the first conductive paths (104) comprise inverted V shapes, inverted U shapes, inverted M shapes, inverted W shapes, inverted ladder shapes, or a combination thereof, and the second conductive paths (204) comprise V shapes, U shapes, M shapes, W shapes, ladder shapes, or a combination thereof; or
wherein the first semiconductor component (100, 102) and the second semiconductor component (200, 202) are semiconductor dies.

5. The semiconductor device (100, 200, 300, 400, 500) as claimed in claim 1, wherein the first semiconductor component (100, 102) is a semiconductor die, and the second semiconductor component (200, 202) is an interposer;
optionally further comprising: conductive lines (402) extending along a top surface of the second semiconductor component (200, 202) and electrically coupling the plurality of second conductive paths (204) to the plurality of first conductive paths (104).

6. The semiconductor device (100, 200, 300, 400, 500) as claimed in claim 1, further comprising:
a substrate (502) stacked below the second semiconductor component (200, 202),
wherein the damage detection structure (302) further comprises a plurality of third conductive paths (504, 506) disposed in the substrate (502) and electrically coupled to the plurality of first conductive paths (104) and/or the plurality of second conductive paths (204).

7. A semiconductor device (100, 200, 300, 400, 500), comprising:
a first semiconductor component (100, 102) vertically overlapping a second semiconductor component (200, 202); and
a damage detection structure (302) comprising:
a plurality of first conductive paths (104) extending along a first edge of the first semiconductor component (100, 102); and
a plurality of second conductive paths (204) extending along a second edge of the second semiconductor component (200, 202) and electrically coupled to the plurality of first conductive paths (104),
wherein the plurality of first conductive paths (104) and the plurality of second conductive paths (204) are in a first staggered arrangement.

8. The semiconductor device (100, 200, 300, 400, 500) as claimed in claim 7, wherein the first semiconductor component (100, 102) and the second semiconductor component (200, 202) are assembled face-to-face.

9. The semiconductor device (100, 200, 300, 400, 500) as claimed in claim 7, further comprising:
conductive terminals (306) disposed over a top surface of the first semiconductor component (100, 102) and/or below a bottom surface of the second semiconductor component (200, 202),
wherein the conductive terminals (306) are electrically coupled to the plurality of first conductive paths (104) and the plurality of second conductive paths (204).

10. The semiconductor device (100, 200, 300, 400, 500) as claimed in claim 7, further comprising:
a plurality of first dielectric layers (106) separating adjacent first conductive paths (104); and
a plurality of second dielectric layers (206) separating adjacent second conductive paths (204),
wherein the plurality of first dielectric layers (106) and the plurality of second dielectric layers (206) are in a second staggered arrangement.

11. The semiconductor device (100, 200, 300, 400, 500) as claimed in claim 7, further comprising: a seal ring (108) surrounding the damage detection structure (302); or
wherein the first edge of the first semiconductor component (100, 102) vertically overlaps the second edge of the second semiconductor component (200, 202); or
wherein the second edge of the second semiconductor component (200, 202) surrounds the first edge of the first semiconductor component (100, 102) in a top view.

12. A semiconductor device (100, 200, 300, 400, 500), comprising:
a first stacked structure (300a) comprising a first semiconductor component (100, 102) and a second semiconductor component (200, 202); and
a damage detection structure (302) disposed in an edge region (101b, 201b) of
the first stacked structure (300a) and comprising a first conductive path,
wherein the first conductive path continuously surrounds a first active area of the first semiconductor component (100, 102) and a second active region (101a, 201a) of the second semiconductor component (200, 202) in a zigzag shape.

13. The semiconductor device (100, 200, 300, 400, 500) as claimed in claim 12, wherein the zigzag shape comprises a plurality of inverted V shapes adjacent to the first active region (101a, 201a) of the first semiconductor component (100, 102) and a plurality of V shapes adjacent to the second active region (101a, 201a) of the second semiconductor component (200, 202);
optionally wherein each of the inverted V shapes is disposed between two of the V shapes in a top view.

14. The semiconductor device (100, 200, 300, 400, 500) as claimed in claim 12, further comprising:
a substrate (502) disposed below the first stacked structure (300a); and
a second stacked structure (300b) disposed over the substrate (502) and comprising a third semiconductor component and a fourth semiconductor component,
wherein the damage detection structure (302) further comprises:
a second conductive path surrounding a third active region (101a, 201a) of the third semiconductor component and a fourth active region (101a, 201a) of the fourth semiconductor component; and
third conductive paths (504, 506) disposed in the substrate (502) and electrically coupling the second conductive path to the first conductive path.

15. The semiconductor device (100, 200, 300, 400, 500) as claimed in claim 12, wherein the first conductive path comprises conductive vias (110, 210) and conductive pads (112, 212).
